# EUROPÄISCHE PATENTSCHRIFT

(11) **EP 2 276 058 B1**
(45) Veröffentlichungstag und Bekanntmachung des Hinweises auf die Patenterteilung: **17.02.2016**
(21) Anmeldenummer: 10182228.6
(22) Anmeldetag: 29.02.2000
(51) Int. Cl.: H01L 21/033, C09D 183/06

(54) **Druckfähige Maskierungspaste**
Printable masking paste
Pâte de masquage imprimable

(30) Priorität: 11.03.1999 DE 19910816
(43) Veröffentlichungstag der Anmeldung: 19.01.2011
(62) Teilanmeldung aus: 00918752.7
(73) Patentinhaber: BASF SE, 67056 Ludwigshafen (DE)
(72) Erfinder: Heider, Lilia, Winchester SO22 4HZ (GB); Wiegand, Claudia, 64291, Darmstadt (DE); Kuebelbeck, Armin, 64625, Bensheim (DE); Stockum, Werner, 64354, Reinheim (DE)

(56) Entgegenhaltungen:
- WO-A1-96/19012
- US-A- 4 785 041
- US-A- 5 057 336

## Beschreibung

Die Erfindung betrifft neue Pasten zur Verwendung als Maskierungspasten in der Halbleiterherstellung, Leistungselektronik oder in photovoltaischen Anwendungen.

Es werden auch Dotierpasten beschrieben, die nicht im Rahmen der Erfindung liegen, die aber dem Verständnis der Erfindung dienen.

Bor- oder Phosphor-Dotierungen von monokristallinen Si-Wafern in der Photovoltaik und bei Leistungshalbleitern (z. B. Dioden, Thyristoren) erfolgen über die Gasphase (z. B. POCl₃, Phosphin, BBr₃) oder mit Feststoffen (Folien oder Feststoffscheiben) oder mit flüssigen Medien wie z. B. Phosphorsäure, und anderen B- bzw. P-organischen Systemen.

Ein unmittelbares strukturiertes Aufbringen ist mit diesen Technologien nicht möglich. Definierte Bereiche können nicht selektiv dotiert werden, ohne aufwendige z. B. photolithographische Prozesse zur Maskierung der Bereiche die nicht dotiert werden sollen, anzuwenden.

In der Photovoltaik kann durch die p++ Dotierung auf der Rückseite ein ganzflächiges oder lokales Back Surface Field (Local BSF) erzielt werden. Bestehende Produktionslinien arbeiten derzeit nur mit einem ganz- flächigen Back Surface Field, welches entweder durch eine AI- Metallschicht oder eine flüssige Borquelle erhalten wird. Lokale BSF sind zur Zeit nur im Labormaßstab verwirklicht worden, aus Gründen die im folgenden noch erläutert werden.

Ein ganzflächiges Back Surface Field ist unter anderem bei dünnen Si- Wafern (≤ 250 µm) besonders vorteilhaft, da sonst der Wirkungsgrad der Zelle deutlich niedriger ausfällt. Ein solches BSF wird zur Zeit bei Si- Wafern von > 300 µm Dicke durch ganzflächiges Bedrucken mit einer Aluminium-Paste erhalten [P. Lölgen ; F. J. Bisschop ; W. C. Sinke ; R. A. Steeman ; L. A. Verhoef et al. 6th PV Science and Engineering Conference, New Delhi, 1992, pp. 239]. Vorteilhaft ist dabei, daß zum einen mit dem Aluminium eine p+ Dotierung, d. h. also ein BSF aufgebaut wird und zum anderen mit dem Aluminium auch der an der Zelle erzeugte Strom abgeführt wird. Bei dünnen Wafern tritt allerdings nach dem Einbrennen der Aluminiumpaste eine Wölbung des Wafers auf. Somit erfordert die weitere Handhabung und Bearbeitung solcher Wafer besondere Maßnahmen, da der Einbau solcher gebogenen Zellen in die üblicherweise plan ausgeführten PV-Module sich ausgesprochen schwierig gestaltet.

In DE 195 08712 C2 und in K. A. Münzer, R. R. King, R. E. Schlosser, H. J. Schmidt, J. Schmalzbauer, S. Sterk, H. L. Mayer, 13th European Photovoltaic Solar Energy Conference, 23-27 10.1995, p. 1398 wird durch ein Spin-on Verfahren mit Bor versucht, dieses Problem zu lösen. Hier- bei wird eine p++ Dotierung durch Bor erzeugt und ein nachfolgender Druck eines Aluminiumrasters mittels Aluminiumpaste durchgeführt.

Nachteile dieses Verfahrens sind
a) der große Materialbedarf des Spin on-Verfahrens
b) der erhebliche apparative Aufwand, mit dem eckige Wafer nach dem Spin on-Verfahren gleichmäßig zu beschichten sind
c) der hohe Durchsatz und die aufwendige Handhabung, welche in einer Massenfertigung nur unter großen Schwierigkeiten zu verwirklichen sind und
d) daß eine selektive Strukturierung der Wafer, wie weiter oben beschrieben nicht möglich ist.

Die US 4785041 A offenbart siebdruckfähige Organosiloxanharzzusammensetzungen, insbesondere solche der Formel 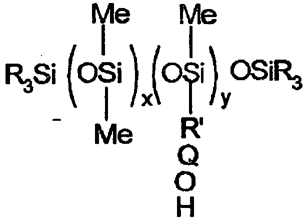 worin Me für Methyl; R für mindestens ein Mitglied der Gruppe bestehend aus einem C1 bis C10 Alkylrest, einem halogenierten C1 bis C10 Alkylrest und einem Phenylradical; R' für einen C3 bis C10 Alkylenrest, Q für - [OCH₂CH(CH₃)]ᵣ steht, x Null oder eine positive ganze Zahl ist, w und y mindestens 1 sind.

Die US 5057336 A offenbart ein Verfahren zur Herstellung von hochreinen dünnen SiO₂ Schichten.

Aufgabe der vorliegenden Erfindung war es daher, verbesserte, preiswerte in der Halbleitertechnik einsetzbare Pasten zur Verfügung zu stellen, die die oben beschriebenen Nachteile nicht aufweisen und in einfacher Weise einsetzbar sind. Aufgabe der vorliegenden Erfindung war es auch, entsprechende siebdruckfähige Pasten zur Verfügung zu stellen.

Offenbart werden Dotierpasten zum selektiven Strukturieren und zum ganzflächigen Bedrucken von Si-Wafern durch Sieb-, Rollen-, Tampon-, Schablonendruck oder andere in der Halbleitertechnologie übliche Drucktechnologien für die Herstellung von p, p+, p++, n, n+, n++-Bereichen im Si-Wafer, enthaltend
a) eine oder mehrere dotierend wirkende Komponenten,
b) eine SiO2-Matrix,
c) Lösungsmittel,
d) gegebenenfalls eine Säure und Wasser
   und gegebenenfalls
e) Additive, wie Verdickungsmittel oder Netzmittel,
wobei die Gesamtzusammensetzung Verunreinigungen in Form von Metallionen in jeweiligen Konzentrationen von weniger als 500 ppb auf- weist, vorzugsweise von weniger als 200 ppb.

Durch Versuche wurde gefunden, daß durch die hiermit gefundenen siebdruckfähigen Dotierpasten die oben angeführten Nachteile entfallen.

Die Pasten können eine Dotierquelle, ausgewählt aus der Gruppe Borsalz, Boroxid, Borsäure, organischen Verbindungen des Bors, Bor-Aluminium-verbindungen und Phosphorsalz, Phosphoroxid, Phosphorpentoxid, Phosphorsäure, phosphororganische Verbindungen und organische Verbindungen des Aluminiums, sowie Aluminium-Salze enthalten.

Prinzipiell geeignet sind die dem Fachmann bekannten Verbindungen v. a. der III. und V. Hauptgruppe des Periodensystems der Elemente.

Weiterhin enthalten die entsprechenden Pasten eine SiO₂-Matrix, bestehend aus einem oder mehreren SiO₂-Precursoren.

Die gefundenen Dotierpasten können ein oder mehrere Dotierquellen ausgewählt aus der Gruppe Boroxid (B₂O₃), Phosphorsäure (H₃PO₄), Phosphorpentoxid (P₂O₅) und Aluminiumsalz enthalten, wobei die Dotierungsquellen in unterschiedlichen Konzentrationen eingesetzt werden können.

Offenbart werden auch Dotierpasten, welche eine oder mehrere Dotierquellen aus der Gruppe der organischen Verbindungen des Bors, Phosphors und Aluminiums enthalten, wobei die Dotierungsquellen in unterschiedlichen Konzentrationen eingesetzt werden können.

Weiterhin offenbart werden Dotierpasten, enthaltend ein oder mehrere Dotierquellen ausgewählt aus der Gruppe Boroxid (B₂O₃), Phosphorsäure (H₃PO₄), Phosphorpentoxid (P₂O₅) und Aluminiumsalz oder Aluminium-organische Verbindungen und gegebenenfalls eine oder mehrere Dotierquellen aus der Gruppe der organischen Verbindungen des Bors, Phosphors und Aluminiums, wobei die Dotierungsquellen in unterschiedlichen Konzentrationen eingesetzt werden können.

Die in der Dotierpaste enthaltene SiO₂-Matrix kann aus silziumorganische Verbindung der allgemeinen Formel

R'ₙSi(OR)₄₋ₙ,

worin
R' Methyl, Ethyl oder Phenyl,
R Methyl, Ethyl, n-Propyl, oder i-Propyl
und
n 0,1 oder 2
bedeuten,
gebildet werden.

Offenbart wird weiterhin eine Dotierpaste, die eine SiO₂ Matrix enthält, welche aus Silanen, ausgewählt aus der Gruppe Tetramethoxysilan, Tetraethoxysilan, Tetrabutoxysilan einzeln oder im Gemisch gebildet wird.

Offenbart wird auch die Verwendung der beschriebenen neuen Dotierpasten in der Halbleitertechnik, der Photovoltaik oder in der Leistungselektronik.

Maskierungspasten wie in Anspruch 1 definiert sind Gegenstand der Erfindung.

Die wie die in gleicher Weise zusammengesetzten oben genannten Dotierpasten, jedoch dotiermittelfreien Maskierungspasten werden erfindungsgemäß in der Halbleitertechnik, der Photovoltaik und in der Leistungselektronik verwendet

Man kann mittels siebdruckfähiger Pasten ebenfalls kostengünstig und mit hohem Durchsatz ganzflächig oder selektiv (selektiver Emitter) eine Phosphordotierung erzielen.

Strukturierungsschritte, die aktuell durch photolithographische Verfahren ermöglicht werden, können kostengünstig durch den Einsatz von siebdruckfähigen Dotierpasten ersetzt werden.

Die Maskierungspaste, die sich als reine Matrixpaste SiO₂ ohne Dotieradditive beschreiben läßt, kann für eine gezielt definierte Schutzschichtbildung herangezogen werden. Zu diesem Zweck kann die Paste vollflächig oder auch strukturiert auf den Si-Wafer aufgebracht werden.

Hierdurch wird es ermöglicht, während des Diffusionsprozesses definierte Bereiche vor einer Dotierung zu schützen.

Offenbart werden neue Pasten zur selektiven Herstellung von dotierten Silikatschichten mit Phosphor, Bor und Bor- Aluminium. Diese Pasten sind geeignet für den Einsatz in drucktechnischen Verfahren in der Elektronikindustrie. Im speziellen zählen hierzu die Siebdrucktechnoiogie oder der Tampondruck.

Je nach gewünschtem Einsatzgebiet können in den verwendeten Pasten sowohl die Konzentrationen der Einzelkomponenten als auch die Viskositäten variiert werden.

Weiterhin zeichnen sich die Dotierpasten durch eine definierte Matrix aus. Diese wird durch eine SiO₂ bildende Komponente beim Aufheizen im Diffussionsprozeß gebildet. Zusammen mit der Bor- bzw. Phosphor-liefernden Komponente bildet sich ein in der Literatur als [K. Spanowsky, Die Diffusion von Bor mit Hilfe von Spin-on- Gläsern in der MOS-Technologie, Diplomarbeit, 1996 ; R. Fischer, Experimente zur Klärung des Diffusionsmechanismus von Phosphor in Silizium, Diplomarbeit, 1994] beschriebenes und dem Fachmann bekanntes Boro-bzw. Phosphorsilikatglas (B₂O₃)ₓ* (SiO₂)_{y} bzw. (P₂O₅)ₓ * (SiO₂)_{y}. Dieses Glas bildet die eigentliche Quelle für den Dotierstoff bei der Dotierung.

Die Menge der SiO₂ bildenden Komponente in der Dotierpaste liegt in einem modifizierbaren Bereich von 0,1-5 Gew.-%. Bezogen auf die Dotierkomponenten B₂O₃ bzw. P₂O₅ kann das Verhältnis SiO₂ zu B₂O₃ bzw. P₂O₅ beliebig eingestellt werden, vorteilhaft ist jedoch der Bereich von 10-80% Dotiermittel in SiO₂. Über dieses Verhältnis kann die zu erreichende Dotierstoffkonzentration im Silizium gut gesteuert werden. Die Eindringtiefe des Dotierstoffes wird, wie in der Literatur bekannt [A. Goetzberger ; B. Voß ; J. Knobloch, Sonnenenergie : Photovoltaik, Teubner Studienbücher Stuttgart 1997, pp 40 ; 107], über die Parameter Diffussionszeit und -temperatur gesteuert.

Der Dotierprozess wird durch ein kontrollierte Diffusion in Luft oder Sauerstoff Atmosphäre durchgeführt. Die Temperaturen für die Phosphordiffusion liegen z. B. bei 900-950°C für Phosphor, für die Bordiffusion bei ca. 950-1250°C. Die Diffusionstemperatur richtet sich auch nach den verwendeten Si-Wafern. Bei monokristallinen Wafern kann die Diffusionstemperatur höher liegen, d. h. bis ca. 1250 °C, da diese temperaturstabiler sind als die multikristallinen Wafer.

Zusätzlich kann die Diffusion auch mit der Rapid Thermal Processing (RTP)-Technologie durchgeführt werden.

Die Diffusionsdauer beträgt kann je nach Anwendungszweck wenige Minuten bis zu 60 Stunden oder mehr betragen. Nach der Diffusion werden die Wafer mit HF (Konzentration ca. 2-50% HF) behandelt, um das gebildete Phosphor-oder Borsilikatglas (PSG, BSG) abzulösen. Nach dieser Behandlung liegt der Si-Wafer mit freier Si-Oberfläche vor.

Die Dotierkomponente liegt im Konzentrationsbereich von 0-10 % bezogen auf die Dotierpaste vor. Bei einer dotierstoff-freien (0 Gew.-%) Zusammensetzung wird eine Maskierungspaste erzeugt. Dieses erfolgt unter den gleichen Prozeßbedingungen wie bei den Dotierpasten.

Das Lösungsmittel bildet den Hauptbestandteil der Paste. Der Anteil kann im Bereich von 50-80 Gew.-% der Gesamtmenge liegen.

Der Anteil der Verdickungsmittel, die zur gezielten Einstellung des Viskositätsbereiches und grundsätzlich zur Druckfähigkeit des Dotiermittels erforderlich sind, d. h. zur Bildung einer druckfähigen Paste, liegt im Bereich von ca. 1-20 Gew.-% bezogen auf die Gesamtmenge der Paste.

Weitere Additive mit für den gewünschten Zweck vorteilhaften Eigenschaften sind Entschäumer, Haftvermittler, Verdickungsmittel, Netzmittel, Verlaufsmittel oder Thixotropiermittel. Diese können die Druckfähigkeit der Paste positiv beeinflußen.

Zur Bildung der Silizium-Matrix werden Silane der allgemeinen Formel :

R'ₙSi(OR)₄₋ₙ verwendet,

worin
R' Methyl, Ethyl oder Phenyl,
R Methyl, Ethyl, n-Propyl, oder i-Propyl
und
n 0,1 oder 2
bedeuten.

Beispiele für geeignete Silane sind Tetramethoxysilan, Tetraethoxysilan, Tetrabutoxysilan, Tetrapropoxysilan, sowie höhere und gemischte Vertreter, d. h. Silane mit längeren Alkylketten bzw. Silane mit unterschiedlichen Alkylresten.

Weiterhin können vorteilhafterweise auch Mischungen verschiedener Alkyl- oder Alkoxysilane eingesetzt werden.

Gegebenenfalls müssen diese Verbindungen vorhydrolysiert werden. Vorteilhaft für die Herstellung der erfindungsgemäßen Pasten ist die Verwendung solcher Siloxane, die keiner Vorbehandlung bedürfen, wie z. B. Polysiloxane.

Beim Erhitzen der Substrate im Diffussionsofen bilden die siliziumorganischen Verbindungen Siliziumdioxid z. B. nach folgender Gleichung:

C₈H₂₀O₄Si → CO₂ + H₂O + SiO₂

(TEOS, Tetraethylorthosilicat)

Zur Herstellung der Dotiermatrix können als anorganische Komponenten von Verbindungen des Bors und Phosphors, sowie Aluminiumverbindungen eingesetzt werden. Beispiele hierfür sind Boroxid B₂O₃, Borsäure B(OH)₃, Phoshorsäure H₃PO₄, P₂O₅ und Al-Salze oder Aluminium-organische Verbindungen.

Als organische Komponenten sind organische Verbindungen des Bors und Phosphors, sowie aluminiumorganische Verbindungen einsetzbar.

Weiterhin können den erfindungsgemäßen Pasten Additive hinzugefügt sein. Dieses können sowohl organische als auch anorganische Säuren sein, wie z. B. Salpetersäure, Salzsäure, Milchsäure, Oxalsäure, Ameisensäure oder andere. Insbesondere werden diese Säuren hinzugefügt, wenn eine Hydrolyse der Si-organischen Verbindung durchgeführt werden muß. Allgemein sind solche organischen Säuren einsetzbar, deren Alkylreste eine Kettenlänge von n = 1-10 aufweisen. Es können organische Säuren eingesetzt werden, die einen Rest R = OH oder = Alkyl mit n = 1-10 aufweisen. Die Alkylreste der einsetzbaren Säuren können sowohl geradkettig als auch verzweigt sein.

Entsprechende Additive in den erfindungsgemäßen Pasten sind notwendig, wenn die siliziumorganische Verbindung vorhydrolysiert werden muß. Bei Siloxan jedoch beispielsweise kann dieses Additiv entfallen.

Als Verdickungsmittel sind Thixoton (Rizinusöl), BorchigenTSW (rheologisches Additiv für Kieselsäuren), Bentonite unterschiedlicher Qualitäten und Eigenschaften, allgemein anorganische Rheologie-Additive für unterschiedlich polare Lösungsmittelgemische, Nitrocellulose, Ethylcellulose und andere Celluloseverbindungen, Poiyvinylpyrollidone unterschiedlicher Qualität, Stärke (+NH₄OH), Gelatine, Alginsäure, hochdisperse amorphe Kieselsäure (Aerosil^{®}), Polyvinylbutyral (Mowital^{®}) (gut löslich z. B. in Butylglycol, Natriumcarboxylmethylstärke (vivastar), thermoplastisches Polyamidharz (Eurelono) (muß verkocht werden bei ca. 180°C), organisches Rizinusölderivat (Thixin R^{®}), Diamidwachs (Thixatrol plus^{®}), quellende Polyacrylate (Rheolate^{®}), Polyetherharnstoff-Polyurethan (Rheolate^{®}), Polyether-Polyole (Rheolate^{®}) geeignet.

Als Verlaufsmittel können Polysiloxane, Siloxane und Trisiloxane eingesetzt werden.

Besonders gut geeignete Additive sind solche, die eine gute Bindung mit den anderen Komponenten eingehen, vorteilhaft bei Temperaturen unterhalb von 200°C klebfrei vorgetrocknet werden können und bei 200 -500°C rückstandsfrei verbrennen.

Die Viskosität der hochreinen Dotierpaste wird durch das Verdickungs- mittel, wie auch durch das verwendete Lösungsmittel eingestellt.

Eine Grundvoraussetzung für eine gute Dotierpaste in der Photovoltaik ist eine möglichst geringe Verunreinigung mit metallischen Verbindungen. Insbesondere die Kationen der Metalle Eisen, Chrom, Kupfer, Nickel, Gold, Calcium usw., vielfach in der Literatur als "Killer"- Trägerlebensdauer bezeichnet, sind unerwünscht. Ihre Konzentrationen sollten möglichst unterhalb von 500 ppb in der Paste liegen. In einigen Fällen sollten die Konzentrationen möglichst 200 ppb nicht überschreiten. Um diese Bedingungen einhalten zu können, sind in einigen Fällen nur aufgereinigte Ausgangsmaterialien einsetzbar.

Außer den bisher genannten Komponenten ist zur Herstellung der Pasten die Zugabe von Lösungsmittel notwendig.

Geeignete organische Lösungsmittel sind hydrophile Polyalkohole, wie Ethylenglykol, Methylcellosolve, Methylcellosolveacetat, Ethylcellusolve, Diethylcellosolve, Cellosolveacetat, Ethylenglykolmonobutylether, Ethylenglykolmonophenylether, Methoxymethoxyethanol, Ethylengklykolmonoacetat, Ethylenglykoldiacetat, Diethylenglykol, Diethylenglykolmono- methylether, Diethylenglykolmonoethyletheracetat, Diethylenglykolmonobutylether, Diethylenglykolmonobutyletheracetat, Diethylenglykoldimethylether, Diethylenglykolmethylethylether, Diethylenglykoldiethylether, Diethylenglykolacetat, Triethylglykol, Triethylenglykolmonomethylether, Triethylenglykolmonoethylether, Tetraethylenglykol, Fl. Polyethylenglykole, Propylenglykol, Propylenglykolmonomethylether, Propylenglykolmonoethylether, Propylenglykolmonbutylether, 1- Buthoxyethoxypropanol, Dipropylglykol, Dipropylenglykolmonomethylether, Dipropytenglykolmonoethylether, Tripropylenglykolmonomethylether, Polypropylenglykole, Trimethylenglykol, Butandial, 1,5- Pentandial, Hexylenglykol, Glycerin, Glycerylacetat, Glyceryldiacetat, Glyceryltriacetat, Trimethylolpropyn, 1,2,6,-Haxantriol oder deren hydrophile Derivate, sowie aliphatische und aromatische mehrwertige Alkohole, wie z. B. 1,2-Propandiol, 1,5-Pentandiol, Oktandiol aber auch deren Ester und Ether oder Gemische dieser Lösungsmittel.

Ein geeignetes Lösungmittel kann beispielsweise als Hauptbestandteil 1,2- Butandiol enthalten. Als geeignet haben sich solche Lösungsmittelgemische erwiesen in denen 30-95 Gew% 1,5 Pentandiol enthalten sind. In einem solchen Gemisch können Ethylenglycolmonobutylether (EGB), Diethylenglycolmonobutylether (DGB), Dipropylenglycolmonomethylether (DPM), 1.4 Butandiol (1.4BD), und 1.3 Butandiol (1.3BD) als weitere Lösungsmittel enthalten sein.

Weiterhin können als Lösungsmittel hydophile Ether, wie Dioxan, Trioxan, Tetrahydrofuran, Tetrahydropyran eingesetzt werden. Geeignet sind auch Methylal, Diethylacetal, Methylethylketon, Methylisobutylketon, Diethylketon, Acetonylaceton, Diacetonalkohol oder hydrophile Ester, wie Ameisensäuremethyl-, Ameisensäureethyl-, Ameisensäurepropyl-, Essigsäuremethyl-, Essigsäureethylester.

Versuche haben gezeigt, daß zur Erreichung eines Dotiereffekts eine Belegung eines üblicherweise eingesetzten Wafers, z. B. 4 Zoll Wafer, mit einer Menge von 50-100 mg Paste ausreicht. Die Belegung der zu behandelnden Wafer mit der erfindungsgemäßen Paste kann mit dem Fachmann bekannten Methoden erfolgen. Insbesondere eignet sich für diesen Zweck das Aufbringen im Siebdruckverfahren. Die Umwandlung der aufgebrachten Pasten in die erwünschten dotierten Schichten erfolgt in bekannter Weise durch Erhitzen auf Temperaturen 200 bis 600 °C, vorzugsweise auf etwa 500 °C. Die erforderliche Dauer des Erhitzens ist abhängig von der Dicke der aufgebrachten Schicht Paste.

Die Paste eignet sich zur Herstellung von p-n- Übergängen, wie z. B. in der Halbleitertechnik, insbesondere aber auch zur Verwendung in der Herstellung von in der Solartechnik verwendeten Solarzellen.

Beispielsweise wurde gefunden, daß sich durch Verwendung von Borpasten zur Herstellung von dotierten Glasschichten der Wirkungsgrad von Solarzellen, der üblicherweise in der Produktion bei 14 % liegt, um ca. 1,5 bis 2% gesteigert wird.

### Ausführungsformen:

1. Maskierungspaste, wie in Anspruch 1 definiert.
2. Verwendung einer Maskierungspaste gemäß Ausführungsform 1 in der Halbleitertechnik, der Photovoltaik und In der Leistungselektronik.

Zum besseren Verständnis und zur Verdeutlichung werden im folgen- den Beispiele gegeben.

### Beispiel 1 :

TEOS (1,43 g) wird in einem Becherglas vorgelegt. Im Anschluß daran wird das Lösungsmittel N-Methyl-pyrrolidon NMP (83 g) hinzugegeben und mit Hilfe eines Rührers die Grundmischung hergestellt. Nun erfolgt die sukzessive Zugabe von Polyvinylpyrrolidon (11 g), von di-Bortrioxid (4,6 g) und zum Abschluß Milchsäure (3 g). Während der Zugabe muß weiterhin intensiv gerührt werden. Nach Abschluß der Zugabe wird die Mischung für ca. weitere 30 min gerührt. Die Abfüllung in Behälter er- folgt nach einer kurzen Standzeit. Diese Standzeit ist erforderlich, damit sich die in der Mischung gebildeten Bläschen auflösen können.

Diese Mischung ergibt eine Paste, wodurch ein Bor-Glas auf dem Wafer gebildet wird, d. h. es wird gezielt eine Dotierung des monokristallinen und polykristallinen Si-Wafers in gewünschter Borkonzentration erhalten.

Die erhaltene Paste ist lagerstabil, leicht zu handhaben und druckfähig.

Sie kann mit üblichen Lösungsmitteln aus der Siebdruckgewebe entfernt werden.

### 2. Beispiele für Pasten mit einem Lösungsmittel oder mit Lösungsmittelgemischen :

### I. P-Paste:

| | | |
|---|---|---|
| 30g | 1.4-Butandiol | |
| 5g | P203 | |
| 53g | 1.2-Propandiol | |
| 1,5g | Trasil^{®} | (Siliziumquelle ; Alkylsilikonharz mit Alkoxygruppen) |
| 0,2g | Foamex N^{®} | (Polydimethylsiloxan ; Entlüfter) |
| 0,2g | Aerex^{®} | (hochmolekulares organisches Polymer mit Siliconspitze ; Entschäumer) |
| 3g | Byk 410^{®} | (modifizierter Harnstoff ; Thixotropiermittel) |
| 0,05g | TEGO Glide 400^{®} (Polyether-modifizierte Polysiloxane ; Verlaufsmittel) | |
| 4g | PVP | (Polyvinylpyrrolidon ; Verdicker) |

### II. Borpaste

| | | |
|---|---|---|
| 83 g | 1,2-Propandiol | |
| 4,6 g | B₂O₃ | |
| 1,43 g | TEOS | |
| 3 g | Milchsäure | |
| 2,5 g | Byk 410^{®} | Thixotropiermittel |
| 0,05g | TEGO Glide 400^{®} | Verlaufsmittel |
| 0,2 g | Aerex^{®} | Entschäumer |
| 0,2 g | Foamex N^{®} | Entlüfter |
| 4 g | PVP | Verdicker |

### II. Si-Paste

| | | |
|---|---|---|
| 48g | 1.2-Propandiol | |
| 3g | TEOS | |
| 3g | Milchsäure | |
| 5g | Ethylenglykolmonobutylether | |
| 3g | Trasil^{®} | |
| 5g | Byk 410^{®} | Thixotropiermittel |
| 0,4g | TEGO Glide 400^{®} | Verlaufsmittel |
| 4g | PVP | Verdicker. |

## Patentansprüche

1. Druckfähige, dotiermittelfreie Maskierungspaste, enthaltend
a) eine SiO₂-Matrix, die aus einem oder mehreren Silan(en) der allgemeinen Formel R'ₙSi(OR)₄₋ₙ, die gegebenenfalls vorhydrolysiert werden müssen,
worin
R' Methyl, Ethyl oder Phenyl,
R Methyl, Ethyl, n-Propyl, oder i-Propyl
und
n 0, 1 oder 2
bedeuten, gebildet wird,
b) Lösungsmittel,
wobei die Gesamtzusammensetzung Verunreinigungen in Form von Metallionen in jeweiligen Konzentrationen von weniger als 500 ppb, vorzugsweise von weniger als 200 ppb aufweist.

2. Maskierungspaste gemäß Anspruch 1, enthaltend Silane, ausgewählt aus der Gruppe Tetramethoxysilan, Tetraethoxysilan, Tetrabutoxysilan, Tetrapropoxysilan, Tetramethoxysilan einzeln oder im Gemisch.

3. Maskierungspaste gemäß einem der Ansprüche 1 bis 2, enthaltend ein oder mehrere Lösungsmittel ausgewählt aus der Gruppe der hydrophilen Polyalkohole, deren Ether oder Ester, der hydrophilen Ether, Aldehyde, Ketone oder Ester oder Gemische.

4. Maskierungspaste gemäß einem der Ansprüche 1 bis 3, enthaltend 30 - 95 Gew% 1,2 Propandiol im Gemisch mit einem oder mehreren Lösungsmitteln ausgewählt aus der Gruppe Ethylenglycolmonobutylether (EGB), Diethylenglycolmonobutylether (DGB), Dipropylenglycolmcnomethylether (DPM), 1.4 Butandiol (1.4BD), und 1.3 Butandiol (1.3BD).

5. Maskierungspaste gemäß einem der Ansprüche 1 bis 4, enthaltend ein oder mehrere Lösungsmittel ausgewählt aus der Gruppe Dioxan, Trioxan, Tetrahydrofuran, Tetrahydropyran, Methylal, Diethylacetal, Methylethylketon, Methylisobutylketon, Diethylketon, Acetonylaceton, Diacetonalkohol, Ameisensäuremethylester, Ameisensäureethylester, Ameisensäurepropylester, Essigsäuremethylester, und Essigsäureethylester.

6. Maskierungspaste gemäß einem der Ansprüche 1 bis 5, enthaltend eine Säure und Wasser und gegebenenfalls Additive, wie Verdickungsmittel oder Netzmittel.

7. Verwendung einer Maskierungspaste gemäß einem der Ansprüche 1 bis 6 in drucktechnischen Verfahren in der Elektronikindustrie.

8. Verwendung einer Maskierungspaste gemäß einem der Ansprüche 1 bis 6 zur Schutzschichtbildung in der Halbleitertechnik, der Photovoltaik und in der Leistungselektronik.

## Claims

1. A printable dopant-free masking paste comprising
a) an SiO₂ matrix which is formed from one or more silane(s) of the general formula R'ₙSi(OR)₄₋ₙ, some of which may need to be prehydrolyzed,
in which
R' is methyl, ethyl or phenyl,
R is methyl, ethyl, n-propyl or i-propyl, and
n is 0, 1 or 2,
b) solvent,
wherein the overall composition has impurities in the form of metal ions in respective concentrations of less than 500 ppb, preferably of less than 200 ppb.

2. The masking paste according to claim 1, comprising silanes selected from the group of tetramethoxysilane, tetraethoxysilane, tetra-butoxysilane, tetrapropoxysilane, tetramthoxysilane, individually or in a mixture.

3. The masking paste according to either of claims 1 and 2, comprising one or more solvents selected from the group of the hydrophilic polyalcohols, ethers or esters thereof, the hydrophilic ethers, aldehydes, ketones or esters or mixtures.

4. The masking paste according to any of claims 1 to 3, comprising 30%-95% by weight of 1,2-propanediol in a mixture with one or more solvents selected from the group of ethylene glycol monobutyl ether (EGB), diethylene glycol monobutyl ether (DGB), dipropylene glycol monomethyl ether (DPM), 1,4-butanediol (1,4-BD) and 1,3-butanediol (1,3-BD).

5. The masking paste according to any of claims 1 to 4, comprising one or more solvents selected from the group of dioxane, trioxane, tetrahydrofuran and tetrahydropyran, methylal, diethyl acetal, methyl ethyl ketone, methyl isobutyl ketone, diethyl ketone, acetonylacetone, diacetone alcohol, methyl formate, ethyl formate, propyl formate, methyl acetate and ethyl acetate.

6. The masking paste according to any of claims 1 to 5, comprising an acid and water and optionally additives such as thickeners or wetting agents.

7. The use of a masking paste according to one or more of claims 1 to 6 in printing processes in the electronics industry.

8. The use of a masking paste according to one or more of claims 1 to 6 for protective layer formation in semiconductor technology, photovoltaics and in power electronics.

## Revendications

1. Pâte de masquage imprimable sans agent dopant, contenant :
a) une matrice SiO₂ formée d'un ou de plusieurs silanes de formule générale R'ₙSi(OR)₄₋ₙ, qui doivent éventuellement être pré-hydrolysés,
dans laquelle
R' signifie méthyle, éthyle ou phényle,
R signifie méthyle, éthyle, n-propyle ou i-propyle, et
n signifie 0, 1 ou 2,
b) des solvants,
la composition totale comprenant des impuretés sous la forme d'ions métalliques en concentrations respectives de moins de 500 ppb, de préférence de moins de 200 ppb.

2. Pâte de masquage selon la revendication 1, contenant des silanes, choisis dans le groupe constitué par le tétraméthoxysilane, le tétraéthoxysilane, le tétrabutoxysilane, le tétrapropoxysilane, le tétraméthoxysilane, seuls ou en mélange.

3. Pâte de masquage selon l'une quelconque des revendications 1 à 2, contenant un ou plusieurs solvants choisis dans le groupe constitué par les polyalcools hydrophiles, leurs éthers ou esters, les éthers hydrophiles, les aldéhydes, les cétones ou les esters ou leurs mélanges.

4. Pâte de masquage selon l'une quelconque des revendications 1 à 3, contenant 30 à 95 % en poids de 1,2-propanediol en mélange avec un ou plusieurs solvants choisis dans le groupe constitué par l'éther monobutylique d'éthylène glycol (EGB), l'éther monobutylique de diéthylène glycol (DGB), l'éther monométhylique de dipropylène glycol (DPM), le 1,4-butanediol (1,4BD) et le 1,3-butanediol (1,3BD).

5. Pâte de masquage selon l'une quelconque des revendications 1 à 4, contenant un ou plusieurs solvants choisis dans le groupe constitué par le dioxane, le trioxane, le tétrahydrofurane, le tétrahydropyrane, le méthylal, le diéthylacétal, la méthyléthylcétone, la méthylisobutylcétone, la diéthylcétone, l'acétonylacétone, l'alcool diacétonique, l'ester méthylique de l'acide formique, l'ester éthylique de l'acide formique, l'ester propylique de l'acide formique, l'ester méthylique de l'acide acétique et l'ester éthylique de l'acide acétique.

6. Pâte de masquage selon l'une quelconque des revendications 1 à 5, contenant un acide et de l'eau, et éventuellement des additifs, tels que des épaississants ou des agents mouillants.

7. Utilisation d'une pâte de masquage selon l'une quelconque des revendications 1 à 6 dans des procédés techniques d'impression dans l'industrie électronique.

8. Utilisation d'une pâte de masquage selon l'une quelconque des revendications 1 à 6 pour la formation de couches de protection dans la technologie des semi-conducteurs, la photovoltaïque et l'électronique de puissance.
